# EUROPEAN PATENT APPLICATION

(11) **EP 2 076 104 A2**
(43) Date of publication of application: **01.07.2009**
(21) Application number: 08009009.5
(22) Date of filing: 15.05.2008
(51) Int. Cl.: H05K 3/24

(54) **Flexible film and display device comprising the same**

(30) Priority: 27.12.2007 KR 20070138829
(71) Applicant: LG Electronics Inc., Seoul 150-010 (KR)
(72) Inventor: Lee, Sang Gon, Chungju-si Choongchungbuk-do 361-480 (KR); Kim, Dae Sung, Chungju-si Choongchungbuk-do 361-480 (KR); Chang, Woo Hyuck, Chungju-si Choongchungbuk-do 361-480 (KR)
(74) Representative: Katérle, Axel

(57) **Abstract**

Provided is a flexible film which includes a dielectric film, a metal layer formed on the dielectric film, circuit patterns formed on the metal layer, and a tin-based bonding layer formed on the circuit patterns. Thus, it is possible to improve the reliability, thermal resistance, and dimension stability of a flexible film and enhance the adhesion between circuit patterns and an integrated circuit (IC) of a flexible film and between circuit patterns and circuit electrodes of a display device.

## Description

This application claims priority from Korean Patent Application No. 10-2007-0138829 filed on Dec. 27, 2007 in the Korean Intellectual Property Office, the disclosure of which is incorporated herein by reference in its entirety.

### BACKGROUND OF THE INVENTION

### 1. Field of the Invention

The present invention relates to a flexible film, and more particularly, to a flexible film which includes a dielectric film, a metal layer formed on the dielectric film, circuit patterns formed on the metal layer, and a tin-based bonding layer formed on the circuit patterns and can thus contribute to the improvement of reliability, thermal resistance, and dimension stability and can enhance the adhesion between an integrated circuit (IC) and circuit patterns.

### 2. Description of the Related Art

With recent improvements in flat panel display technology, various types of flat panel display devices such as a liquid crystal display (LCD), a plasma display panel (PDP), and an organic light-emitting diode (OLED) have been developed. Flat panel display devices include a driving unit and a panel and display images by transmitting image signals from the driving unit to a plurality of electrodes included in the panel.

Printed circuit boards (PCBs) may be used as the driving units of flat panel display devices. That is, PCBs may apply image signals to a plurality of electrodes included in a panel and thus enable the panel to display images. The driving units of flat panel display devices may transmit image signals to a plurality of electrodes of a panel using a chip-on-glass (COG) method.

### SUMMARY OF THE INVENTION

The present invention provides a flexible film, which includes a dielectric film, a metal layer formed on the dielectric film, circuit patterns formed on the metal layer, and a tin-based bonding layer formed on the circuit patterns and can thus contribute to the improvement of reliability, thermal resistance, and dimension stability and can enhance the adhesion between an integrated circuit (IC) and circuit patterns, and a display device including the flexible film.

According to an aspect of the present invention, there is provided a flexible film including a dielectric film; and a metal layer disposed on the dielectric film, wherein the metal layer includes circuit patterns and a tin-based bonding layer disposed on the circuit patterns.

According to an aspect of the present invention, there is provided a flexible film including a dielectric film; a metal layer disposed on the dielectric film; and an integrated circuit (IC) chip disposed on the metal layer, wherein the metal layer includes circuit patterns and a tin-based bonding layer formed on the circuit patterns.

According to another aspect of the present invention, there is provided a display device including a panel; a driving unit; and a flexible film disposed between the panel and the driving unit, wherein the flexible film includes a dielectric film and a metal layer disposed on the dielectric film and the metal layer includes circuit patterns and a tin-based bonding layer formed on the circuit patterns.

### BRIEF DESCRIPTION OF THE DRAWINGS

The above and other features and advantages of the present invention will become more apparent by describing in detail preferred embodiments thereof with reference to the attached drawings in which:
FIGS. 1A through 1F illustrate cross-sectional views of flexible films according to embodiments of the present invention;
FIGS. 2A through 2C illustrate diagrams of a tape carrier package (TCP) comprising a flexible film according to an embodiment of the present invention;
FIGS. 3A through 3C illustrate diagrams of a chip-on-film (COF) comprising a flexible film according to an embodiment of the present invention;
FIGS. 4A through 4C illustrate diagrams of a display device according to an embodiment of the present invention;
FIG. 5 illustrates a cross-sectional view of the display device 400 in FIG. 4A; and
FIG. 6 illustrates diagram of a display device according to an embodiment of the present invention.

### DETAILED DESCRIPTION OF THE INVENTION

The present invention will hereinafter be described in detail with reference to the accompanying drawings in which exemplary embodiments of the invention are shown.

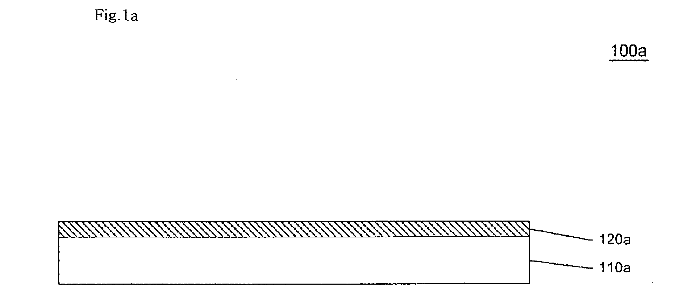

FIGS. 1A through 1F illustrate cross-sectional views of flexible films 100a through 100f, respectively, according to embodiments of the present invention. Referring to FIGS. 1A through 1F, the flexible films 100a through 100f transmit an image signal provided by a driving unit of a tape automated bonding (TAB)-type display device to an electrode on a panel of the TAB-type display device.

More specifically, each of the flexible films 100a through 100f may be formed by forming a metal layer on a dielectric film and printing circuit patterns on the metal layer. Thus, the flexible films 100a through 100f may transmit an image signal provided by a driving unit of a display device to a panel of the display device. Circuit patterns of a flexible film used in a TAB-type display device may be connected to a circuit of a driving unit of the TAB-type display device or to an electrode on a panel of the TAB-type display device and may thus transmit a signal applied by the driving unit to the panel.

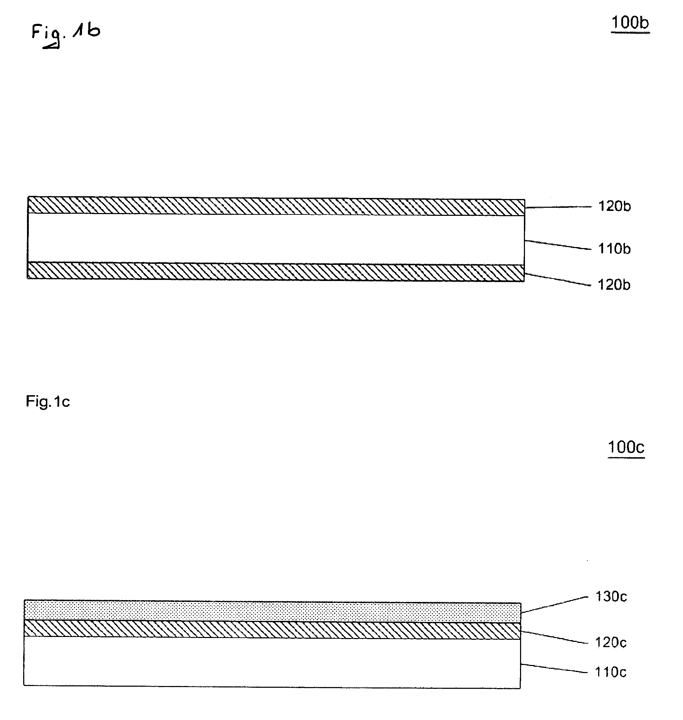

Referring to FIG. 1A, the flexible film 100a includes a dielectric film 110a and a metal layer 120a, which is formed on the dielectric film 110a. Referring to FIG. 1B, the flexible film 100b includes a dielectric film 110b and two metal layers 120b, which are formed on the top surface and the bottom surface, respectively, of the dielectric film 110b.

The metal layer 120a or the metal layers 120b may include a conductive metal and may have circuit patterns printed thereon. The metal layer 120a or the metal layers 120b may also have a tin-based bonding layer formed on the circuit patterns. In order to protect the circuit patterns, a bonding layer may be formed on the circuit patterns as a protective film.

The dielectric film 110a or 110b may include a dielectric polymer material such as polyimide, polyester, or a liquid crystal polymer. The metal layer 120a or the metal layers 120b may include nickel, gold, chromium, or copper.

The metal layer 120a or the metal layers 120b may be formed through casting or laminating. More specifically, the metal layer 120a or the metal layers 120b may be formed through casting by applying a liquid-phase dielectric film on a metal film and drying and hardening the metal film in an oven at high temperature. Alternatively, the flexible film 100a or 100b may be formed through laminating by applying an adhesive on the dielectric film 110a or 1 10b, baking the dielectric film 110a or 1 10b so as to fix the adhesive on the dielectric film I 10a or 110b, placing the metal layer 120a or the metal layers 120b on the dielectric film 110a or 110b, and performing press processing on the metal layer 120a or the metal layers 120b.

The metal layer 120a or the metal layers 120b may include nickel, copper, gold or chromium, and particularly, an alloy of nickel and chromium. More specifically, the metal layer 120a or the metal layers 120b may be formed of an alloy of 97% nickel and 3% chromium or an alloy of 93% nickel and 7% chromium. If the metal layer 120a or the metal layers 120b are formed of an alloy of nickel and chromium, the thermal resistance of the flexible film 100a or 100b may increase. The metal layer 120a or the metal layers 120b may be formed to a thickness of 4-13 µm in consideration of the peel strength and the properties of the flexible film 100a or 100b.

Once the metal layer 120a or the metal layers 120b are formed, circuit patterns are formed by etching the metal layer 120a or the metal layers 120b, and a bonding layer is formed on the circuit patterns. The bonding layer may facilitate soldering for connecting the circuit patterns to an electrode or an integrated circuit (IC). The bonding layer may include tin. The bonding of the circuit patterns to an electrode or an IC may be easier when the bonding layer is formed of tin, which has a melting temperature of 300°C or lower, than when the bonding layer is formed of lead, which has a melting temperature of 300°C or higher.

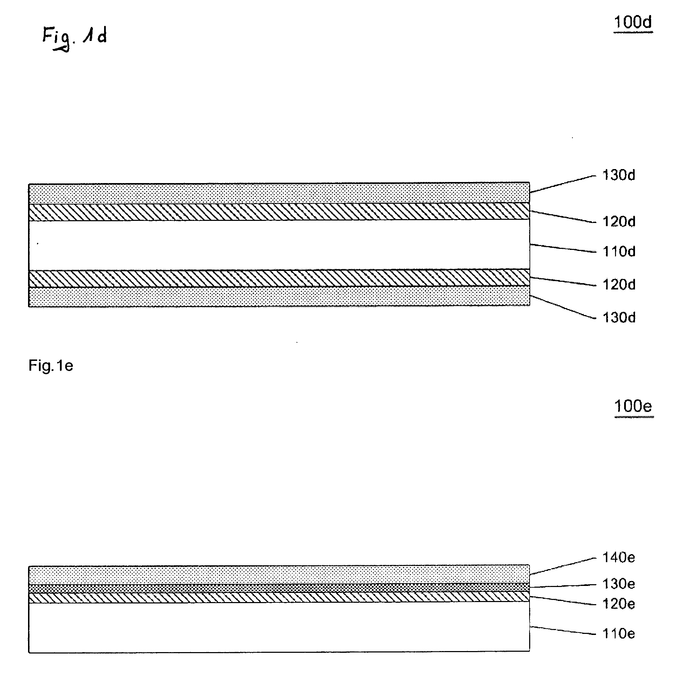

Referring to FIG. 1C, the flexible film 100c includes a dielectric film 110c and two metal layers, i.e., first and second metal layers 120c and 130c. The first metal layer 120c is disposed on the dielectric film 1 10c, and the second metal layer 130c is disposed on the first metal layer 120c. Referring to FIG. 1D, the flexible film 100d includes a dielectric film 1 10c and four metal layers, i.e., two first metal layers 120d and two second metal layers 130d. The two first metal layers 120d are disposed on the top surface and the bottom surface, respectively, of the dielectric film 1 10d, and the two second metal layers 130d are disposed on the respective first metal layers 120d.

The first metal layer 120c or the first metal layers 120d may be formed through sputtering or electroless plating, and may include nickel, chromium, gold or copper.
More specifically, the first metal layer 120c or the first metal layers 120d may be formed through sputtering using an alloy of 93% nickel and 7% chromium or an alloy of 97% nickel and 3% chromium.

The first metal layer 120c or the first metal layers 120d may be formed through electroless plating by immersing the dielectric film 1 10c or 1 10d in an electroless plating solution containing metal ions and adding a reducing agent to the electroless plating solution so as to extract the metal ions as a metal. For example, the first metal layer 120c or the first metal layers 120d may be formed by immersing the dielectric film 1 10c or 110d in a copper sulphate solution, and adding formaldehyde (HCHO) to the copper sulphate solution as a reducing agent so as to extract copper ions from the copper sulphate solution as copper. Alternatively, the first metal layer 120c or the first metal layers 120d may be formed by immersing the dielectric film 1 10c or 1 10d in a nickel sulphate solution, and adding sodium hypophosphite (NaH₂PO₂) to the nickel sulphate solution as a reducing agent so as to extract nickel ions from the nickel sulphate solution as nickel.

The second metal layer 130c or the second metal layers 130d may include gold or copper. More specifically, the second metal layer 130c or the second metal layers 130d may be formed through electroplating, which involves applying a current and thus extracting metal ions as a metal. In this case, the thickness of the second metal layer 130c or the second metal layers 130d may be altered by adjusting the amount of current applied and the duration of the application of a current.

The sum of the thicknesses of the first metal layer 120c and the second metal layer 130c may account for one tenth to two thirds of the thickness of the dielectric film 1 10c.
For example, if the thickness of the dielectric film 1 10c is 15-40 µm, the sum of the thicknesses of the first metal layer 120c and the second metal layer 130c may be 4-13 µm.
More specifically, the first metal layer 120c may have a thickness of about 100 nm, and the second metal layer 130c may have a thickness of about 9 µm. And this applies to a double-sided flexible film.

If the first metal layer 120c or the first metal layers 120d are too thin, a substitution reaction between the first metal layer 120c or the first metal layers 120d and a bonding layer may occur during the formation of the bonding layer. Thus, the first metal layer 120c or the first metal layers 120d may be formed to more than a certain thickness.

Once the first metal layer 120c and the second metal layer 130c or the first metal layers 120d and the second metal layers 130d are formed, circuit patterns may be formed by etching the metal layer and a bonding layer may be formed on the circuit patterns. The bonding layer may facilitate soldering for connecting the circuit patterns to an electrode or an IC. For example, the bonding layer may include tin. The bonding of the circuit patterns to an electrode or an IC may be easier when the bonding layer is formed of tin,
which has a melting temperature of 300°C or lower, than when the bonding layer is formed of lead, which has a melting temperature of 300°C or higher.

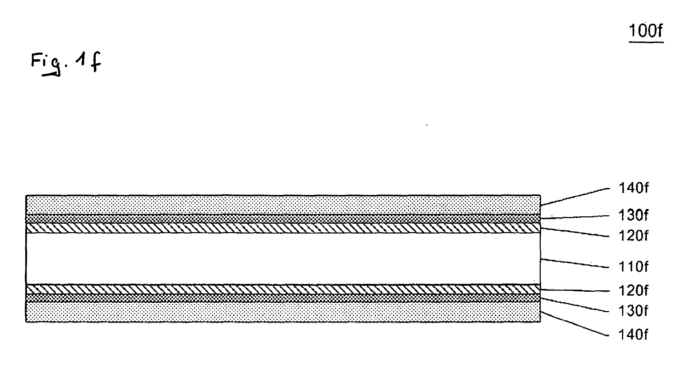

Referring to FIG. 1E, the flexible film 100e includes a dielectric film 110e and three metal layers, i.e., first, second and third metal layers 120e, 130e and 140e. The first metal layer 120e is disposed on the first metal layer 120e, the second metal layer 130e is disposed on the first metal layer 120e, and the third metal layer 140e is formed on the second metal layer 130e. Referring to FIG. 1F, the flexible film 100f includes a dielectric film 110f and six metal layers: two first metal layers 120f, two second metal layers 130f, and two third metal layers 140f. The two first metal layers 120f are disposed on the top surface and the bottom surface, respectively, of the dielectric film 1 10f, the two second metal layers 130f are disposed on the respective first metal layers 120f, and the two third metal layers 140f are disposed on the respective second metal layers 130f.

The first metal layer 120e or the first metal layers 120f may be formed through sputtering or electroless plating, and may include at least one of nickel, chromium, gold or copper. More specifically, the first metal layer 120e or the first metal layers 120f may be formed through sputtering using an alloy of nickel and chromium. Particularly, the first metal layer 120e or the first metal layers 120f may contain 93-97% nickel.

The first metal layer 120e or the first metal layers 120f may be formed through electroless plating by immersing the dielectric film 110e or 11 0f in an electroless plating solution containing metal ions and adding a reducing agent to the electroless plating solution so as to extract the metal ions as a metal. For example, the first metal layer 120e or the first metal layers 120f may be formed by immersing the dielectric film 110e or 110f in a copper sulphate solution, and adding formaldehyde (HCHO) to the copper sulphate solution as a reducing agent so as to extract copper ions from the copper sulphate solution as copper. Alternatively, the first metal layer 120e or the first metal layers 120f may be formed by immersing the dielectric film 1 10e or 1 10f in a nickel sulphate solution, and adding sodium hypophosphite (NaH₂PO₂) to the nickel sulphate solution as a reducing agent so as to extract nickel ions from the nickel sulphate solution as nickel.

The second metal layer 130e or the second metal layers 130f may be formed through sputtering. If the first metal layer 120e or the first metal layers 120f are formed of an alloy of nickel and chromium, the second metal layer 130e or the second metal layers 130f may be formed of a metal having a low resistance such as copper, thereby improving the efficiency of electroplating for forming the third metal layer 140e or the third metal layers 140f.

The third metal layer 140e or the third metal layers 140f may be formed through electroplating, and may include gold or copper. More specifically, the third metal layer 140e or the third metal layers 140f may be formed through electroplating, which involves applying a current to an electroplating solution containing metal ions and thus extracting the metal ions as a metal.

The ratio of the sum of the thicknesses of the first metal layer 120e, the second metal layer 130e, and the third metal layer 140e to the thickness of the dielectric film 1 10e may be 1:1.5 to 1:10. The ratio of the sum of the thicknesses of the first metal layer 120e, the second metal layer 130e, and the third metal layer 140e to the thickness of the dielectric film 1 10e may be determined according to the properties and the peel strength of the flexible film 100e of 100f. And this directly applies to a double-sided flexible film. Once the third metal layer 140e or the third metal layers 140f are formed, circuit patterns may be formed by etching the metal layer and a bonding layer may be formed on the circuit patterns.

The bonding layer may include tin and may be formed on the circuit patterns, to which an IC or a driving unit or a panel of a display device is connected. If the bonding layer is formed of tin, which has a lower melting point than other metals for use in soldering, the bonding layer may facilitate the connection of the circuit patterns to an IC or to a driving unit or a panel of a display device.

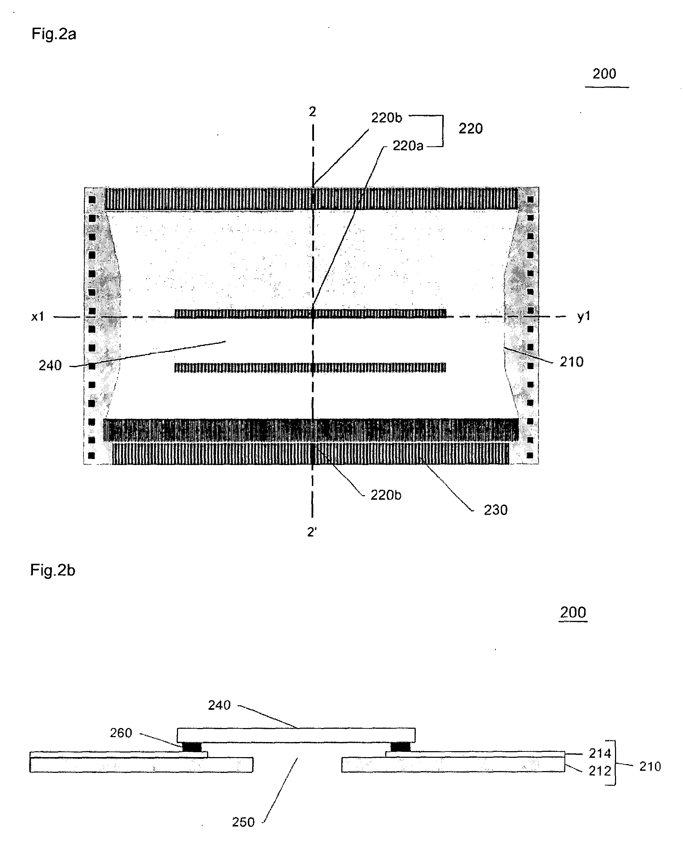

FIGS. 2A through 2C illustrate diagrams of a tape carrier package (TCP) including a flexible film 210 according to an embodiment of the present invention. Referring to FIG. 2A, the TCP 200 includes the flexible film 210, circuit patterns 220, which are
formed on the flexible film 210, and a bonding layer 230, which is formed on the circuit patterns 220, and an IC 240. The TCP 200 may be included in a TAB-type display device, and may thus transmit an image signal provided by a driving unit of the TAB-type display device to an electrode of a panel of the TAB-type display device.

The flexible film 210 may include a dielectric film, which is formed of a polymer material such as polyimide, polyester, or a liquid crystal polymer, and a metal layer, which is formed on the dielectric film. The metal layer may have a single-, double-, or triple-layer structure.

For example, the metal layer may have a double-layer structure including a first metal layer and a second metal layer. The first metal layer may be formed through sputtering or electroless plating and may include nickel, chromium, gold or copper. More specifically, the first metal layer may be formed of an alloy of nickel and chromium, and particularly, an alloy of 97% nickel and 3% chromium or an alloy of 93% nickel and 7% chromium, thereby improving the thermal resistance of the flexible film 210. When using an alloy of nickel and chromium, the first metal layer may be formed through sputtering.

The second metal layer may be formed on the first metal layer through electroplating. If the first metal layer includes an alloy of nickel and chromium, the efficiency of electroplating for forming the second metal layer may decrease due to a high resistance of the first metal layer. In order to address this, the first metal layer may be formed of copper through electroless plating. Since copper has a lower resistance than an alloy of nickel and chromium, it is possible to improve the efficiency of electroplating for forming the second metal layer by forming the first metal layer of copper.

The circuit patterns 220 are printed on the metal layer of the flexible film 210.
The circuit patterns 220 include inner leads 220a, which are connected to the IC 240, and outer leads 220b, which are connected to a driving unit or a panel of a display device.
The inner leads 220a may be connected to the IC 240 through inner lead bonding (ILB) pads, and the outer leads 220b may be connected to a driving unit or a panel of a display device through outer lead bonding (OLB) pads.

The bonding layer 230 may be formed on the circuit patterns 220 and may include tin. More specifically, the bonding layer 230 may be formed on the circuit patterns 220 through electroless plating. If the bonding layer 230 includes tin, the bonding layer 230 may be easily connected to gold bumps on the IC 240 by applying heat or ultrasonic waves so as to generate a gold-tin bond between the gold bumps and the bonding layer 230.

FIG. 2B illustrates a cross-sectional view taken along line 2-2' of FIG. 2A.
Referring to FIG. 2B, the TCP 200 includes the flexible film 210, which has a device hole 250, the IC 240, and gold bumps 260, which connect the bonding layer 230 of the flexible film 210 to the IC 240.

Referring to FIG. 2B, the flexible film 210 includes a dielectric film 212 and a metal layer 214, which is formed on the dielectric film 212. The circuit patterns 220 may be printed on the metal layer 214. The dielectric film 212 may be formed of a dielectric material such as polyimide or a liquid crystal polymer. The metal layer 214 may be formed on the dielectric film 212 through sputtering, electroless plating or electroplating. The circuit patterns 220 may be formed by etching the metal layer 214.

The circuit patterns 220 may include inner leads 220a, which are connected to the IC 240, and outer leads 220b, which are connected to a driving unit or a panel of a display device. The inner leads 220a may have a pitch of about 40 µm, and the outer leads 220b may have a pitch of about 60 µm. The pitch of the circuit patterns 220 may vary
according to the resolution of a display device comprising the TCP 200.

The bonding layer 230 is formed on the circuit patterns 220. More specifically, the circuit patterns 220 are formed on the metal layer 214, and the bonding layer 230 is formed on the circuit patterns 220 through electroless plating. Due to the bonding layer 230, it is possible to easily connect the TCP 200 to a driving unit or a panel of a display device.

If a seed layer of the metal layer 214 is too thin, a substitution reaction between a metal material of the seed layer and the bonding layer 230 may occur during the formation of the bonding layer 230. In order to address this, the seed layer of the metal layer 214 may be formed to more than a certain thickness. For example, the seed layer of the metal layer 214 may have a thickness of 30-100 nm.

The flexible film 210 includes the device hole 250, which is formed in an area in which the IC 240 is disposed. The device hole 250 is formed through the flexible film 210. After the formation of the device hole 250, flying leads are formed on the circuit patterns 220 near the device hole 250, and the IC 240 is connected to the flying leads.
The flying leads may be plated with a metal such as tin, thereby forming tin electrodes.
By applying heat or ultrasonic waves to the tin electrodes, a gold-tin bond may be generated between the tin electrodes and the gold bumps 260.

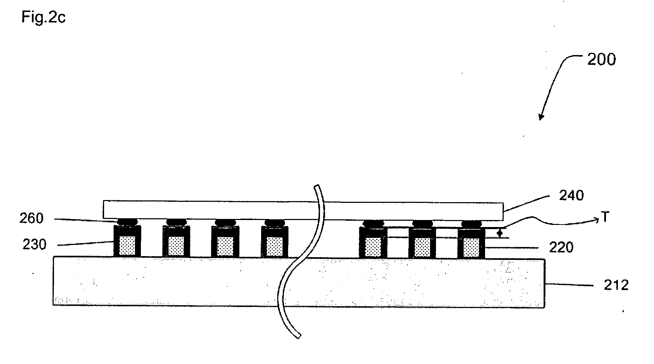

FIG. 2C illustrates a cross-sectional view taken along line x1-y1 of FIG. 2A.
Referring to FIG. 2C, the TCP 200 includes the dielectric film 210, which has the dielectric film 212 and the metal layer 214 formed on the dielectric film 212, the bonding layer 230, which is formed on the circuit patterns 220, and the IC 240, which is connected to the circuit patterns 240 through the bonding layer 230 and the gold bumps 260. The circuit patterns 220 are formed by etching the metal layer 214.

The dielectric film 212 is a base film of the flexible film 210 and may include a polymer material such as polyester, polyimide, or a liquid crystal polymer. The metal layer 214 may be formed on the dielectric film 212. The circuit patterns 220 may be formed by etching the metal layer 214. The bonding layer 230 may be formed on the circuit patterns 220 through electroless plating.

The bonding layer 230 may include tin. In this case, a gold-tin bond may be generated between the bonding layer 230 and the gold bumps 260, and thus, the circuit patterns 220 and the IC 240 may be electrically connected. More specifically, the gold bumps 260 and the bonding layer 230 may be connected by applying heat or ultrasonic waves. Since tin has a lower melting point than other metals for use in soldering, the bonding layer 230 may facilitate the bonding between the IC 240 and the circuit patterns 220.

**Table 1**

| Thickness of | Less than | 50nm | 1 µm | 2 µm | More than |
|---|---|---|---|---|---|
| Bonding layer T | 50nm | | | | 2 µm |
| Adhesiveness | × | ○ | ○ | ○ | ○ |
| Electric Conductivity | ○ | ○ | ○ | ○ | × |

Referring to Table 1, the thickness T of the bonding layer 230 may be 50 nm to 2 µm. If the thickness T of the bonding layer 230 is less than 50 nm, the adhesiveness of the bonding layer 230 may not be strong enough to connect the IC 240 and the circuit patterns 220. On the other hand, if the thickness T of the bonding layer 230 is more than 2µm, the resistance of the bonding layer 230 may too high to properly connect the IC 240 to the circuit patterns 220 electrically.

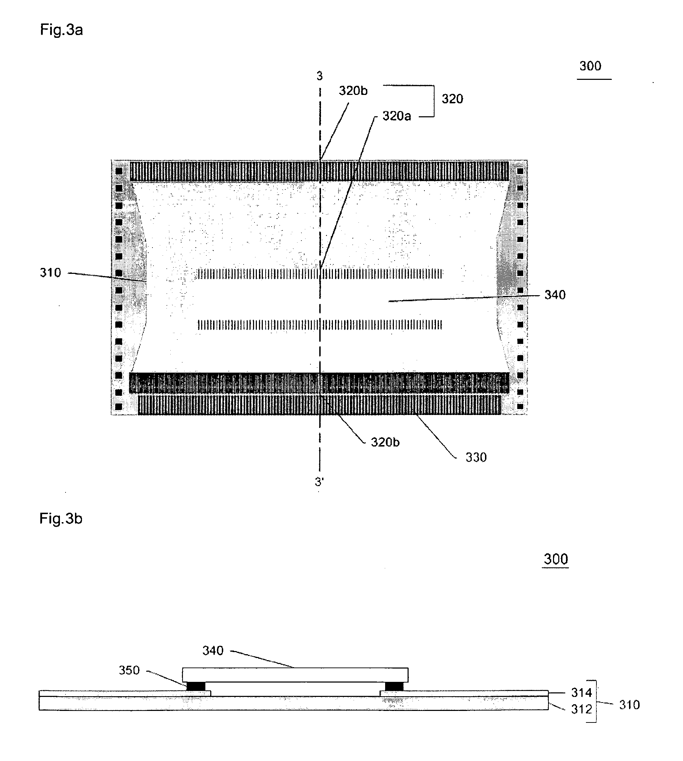

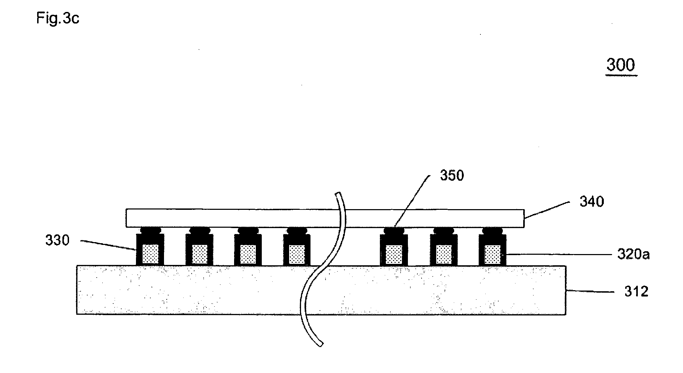

FIGS. 3A through 3C illustrate diagrams of a chip-on-film (COF) 300 including a flexible film 310 according to an embodiment of the present invention. Referring to FIG. 3A, the COF 300 includes the flexible film 310, circuit patterns 320, which are formed on the flexible film 310, a bonding layer 330, which is formed on the circuit patterns 320, and an IC 340.

The flexible film 310 includes a dielectric film 312, which is formed of polyimide, polyester, or a liquid crystal polymer, and a metal layer 314, which is formed on the dielectric film 312. The metal layer 314 may be formed on the dielectric film 312 through sputtering, electroless plating or electroplating. The metal layer 314 may include nickel, chromium, gold or copper. The circuit patterns 320, which are formed on the metal layer 314, may have a pitch of several tens of micrometers.

The circuit patterns 320 may be formed by etching the metal layer 314. Once the circuit patterns 320 are formed, the bonding layer 330 is formed on the circuit patterns 220 through electroless plating. The bonding layer 330 facilitates the connection of the circuit patterns 320 to a driving unit or a panel of a display device or to the IC 340. The bonding layer 330 may be formed of tin on inner leads 320a of the circuit patterns 320. Then, heat or ultrasonic waves may be applied to the bonding layer 330 so that the inner leads 320a can be connected to gold bumps on the IC 340.

During the formation of the bonding layer 330 on the circuit patterns 320, a substitution reaction between the bonding layer 330 and the metal layer 314 may occur. More specifically, if a seed layer of the metal layer 314 is too thin, a substitution reaction may occur between the material of the seed layer and the bonding layer 330 during the formation of the bonding layer 330. Therefore, the seed layer of the metal layer 314 may need to be formed to more than a certain thickness in order to prevent the occurrence of a substitution reaction between the seed layer of the metal layer 314 and the bonding layer 330. The seed layer of the metal layer 314 may be formed to a thickness of 20-100 nm.

The inner leads 320a, to which the IC is connected 340, may have a pitch of about 30 µm. Outer leads 320b of the circuit patterns 320 may have a higher pitch than the inner leads 320a. For example, the outer leads 320b may have a pitch of about 60 µm. The pitch of the circuit patterns 320 may vary according to the resolution of a display device.

The IC 340 is attached on the circuit patterns 320 with the aid of the bonding layer 330. The IC 340 applies an image signal provided by a driving unit of a display device to a panel of the display device, and thus enables the display device to realize an image.

FIG. 3B illustrates a cross-sectional view taken along line 3-3' of FIG. 3A.
Referring to FIG. 3B, the COF 300 includes the flexible film 310, which has the dielectric film 312 and the metal layer 314 formed on the dielectric film 312, the IC 340, which is connected to the circuit patterns 320 on the metal layer 314, and gold bumps 350, which connect the IC 340 to the circuit patterns 320.

The dielectric film 312 is a base film of the flexible film 310 and may include a dielectric polymer material such as polyimide, polyester, or a liquid crystal polymer. The dielectric film 312 may be formed to a thickness of 15-40 µm so as to have appropriate peel strength with respect to the metal layer 314 and appropriate flexibility. More specifically, the dielectric film 314 may be formed to a thickness of 35-38 µm.

The metal layer 314 is a thin film formed of a highly-conductive metal. The metal layer 314 may have a single-, double-, or triple-layer structure. For example, the metal layer 314 may have a double-layer structure including first and second metal layers. The first metal layer may be formed of nickel, chromium, gold or copper through sputtering or electroless plating, and the second metal layer may be formed of gold or copper through electroplating. More specifically, the first metal layer may be formed of an alloy of nickel and chromium, thereby improving the thermal resistance of the flexible film 310.

The first metal layer may serve as a seed layer until the second metal layer is formed thereon. If the first metal layer is formed of an alloy of nickel and chromium, resistance may increase, and thus, the efficiency of electroplating for forming the second metal layer may decrease. In order to address this, a copper layer may additionally be formed on the first metal layer through sputtering before the formation of the second metal layer, thereby obtaining a metal layer 314 having a triple-layer structure and reducing the resistance of the metal layer 314.

The IC 340 is connected to the inner leads 320a of the circuit patterns and thus transmits an image signal provided by a driving unit of a display device to a panel of the display device. The pitch of the inner leads 320a may vary according to the resolution of a display device comprising the COF 300. The inner leads 320a may have a pitch of about 30 µm. The IC 340 may be connected to the inner leads 320a through the gold bumps 350 and the bonding layer 330.

Referring to FIG. 3B, the COF 300, unlike the TCP 200, does not include any device hole. Therefore, the COF 300 does not require the use of flying leads and can thus achieve a fine pitch. In addition, the COF 300 is very flexible, and thus, there is no need to additionally form slits in the COF 300 in order to make the COF 300 flexible. Therefore, the efficiency of the manufacture of the COF 300 can be improved. For example, leads having a pitch of about 40 µm may be formed on the TCP 200, and leads having a pitch of about 30 µm can be formed on the COF 300. Thus, the COF 300 is suitable for use in a display device having a high resolution.

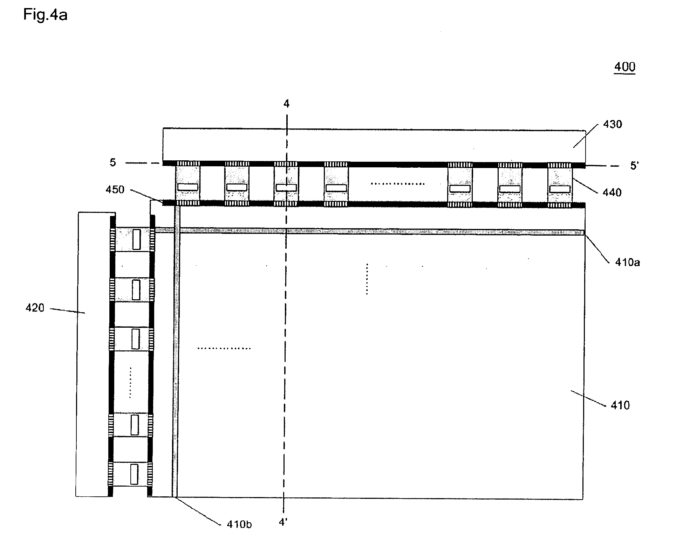

FIGS. 4A through 4C illustrate diagrams of a display device 400 according to an embodiment of the present invention. Referring to FIG. 4A, the display device 400 includes a panel 410, driving units 420 and 430, which apply an image signal to the panel 410, a plurality of flexible films 440, which connect the panel 410 to the driving units 420 and 430, and a plurality of conductive films 450, which attach the flexible films 440 on the panel 410 or on the driving units 420 and 430.

The display device 400 is a flat panel display (FPD) such as a liquid crystal display (LCD), a plasma display panel (PDP), or an organic light-emitting diode (OLED).

The panel 410 includes a plurality of pixels for displaying an image. A plurality of electrodes may be arranged on the panel 410 and may be connected to the driving units 420 and 430. The pixels are disposed at the intersections among the electrodes. More specifically, the electrodes include a plurality of first electrodes 410a and a plurality of second electrodes 410b, which intersect the first electrodes 410a. The first electrodes 410a may be formed in row direction, and the second electrodes 410b may be formed in a column direction.

Each of a plurality of pixels at the intersections between the first electrodes 410a and the second electrodes 410b may or may not include a transistor device according to how the display device 400 is driven. More specifically, if the display device 400 is driven in an active-matrix manner, in which an image is displayed in units of pixels, each pixel may include at least one switching device. On the other hand, if the display device 400 is driven in a passive-matrix manner, each pixel may not include a switching device.

The driving units 420 and 430 may include a scan driver 420 and a data driver 430.
The scan driver 420 may be connected to the first electrodes 410a, and the data driver 430 may be connected to the second electrodes 410b.

The scan driver 420 applies a scan signal to each of the first electrodes 410a and thus enables the data driver 430 to transmit a data signal to each of the second electrodes 410b. When the scan driver 420 applies a scan signal to each of the first electrodes 410a, a data signal can be applied to the first electrodes 410a, and an image can be displayed on the panel 400 according to a data signal transmitted by the data driver 430. Signals transmitted by the scan driver 420 and the data driver 430 may be applied to the panel 400 through the flexible films 440.

The flexible films 440 may have circuit patterns printed thereon. Each of the flexible films 440 may include a dielectric film, a metal layer, which is formed on the dielectric film, and an IC, which is connected to circuit patterns printed on the metal layer. Image signals applied by the driving units 420 and 430 may be transmitted to the first second electrodes 410a and the second electrodes 410b on the panel 410 through the circuit patterns and the IC of each of the flexible films 440. The flexible films 440 may be connected to the panel 410 and to the driving units 420 and 430 by the conductive films 450.

The conductive films 450 are adhesive thin films. The conductive films 450 may be disposed between the panel 410 and the flexible films 440, between the driving units 420 and 430 and the flexible films 440. The conductive films 450 may be anisotropic conductive films (ACFs). Each of the conductive films 450 may contain conductive balls. In this case, signals applied by the driving units 420 and 430 may be transmitted to the panel through the conductive balls of each of the conductive films 450.

Each of the conductive balls in each of the conductive films 450 may include a conductive metal layer. For example, the conductive balls in each of the conductive films 450 may be plastic balls coated with a metal layer or may be metal balls including at least one nickel- or copper-based metal layer. Alternatively, the conductive balls in each of the conductive films 450 may be metal balls coated with a thin plastic film. In the latter case, the thin plastic film of each of the conductive balls in each of the conductive films 450
may be destroyed during the attachment of the flexible films 440 on the panel 410 or on the driving units 420 and 430, and thus, the conductive balls in each of the conductive films 450 may be able to transmit image signals.

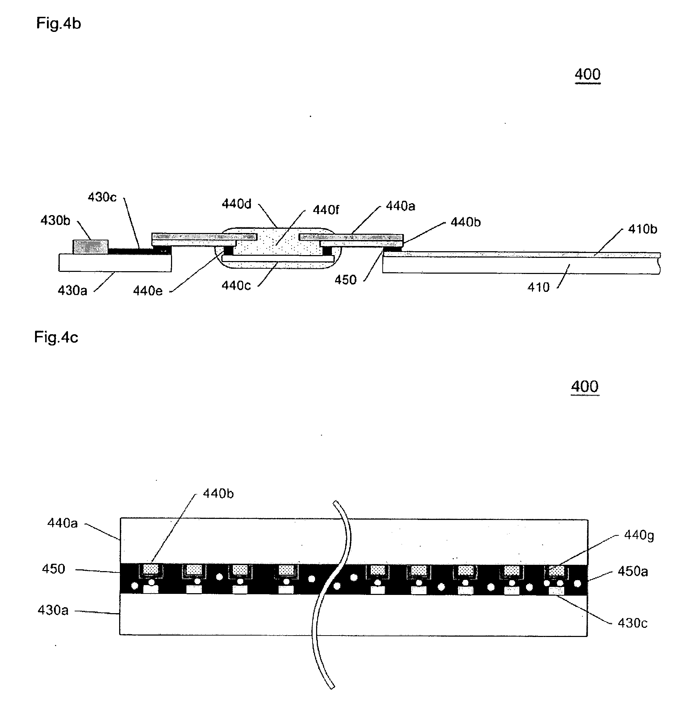

FIG. 4B illustrates a cross-sectional view taken along line 4-4' of FIG. 4A.
Referring to FIG. 4B, a bonding pad 410b, which is formed on the panel 410, is connected to a circuit pattern 440b, which is formed on a flexible film 440, by a conductive film 450. A circuit pattern 440b, which is formed on another flexible film 440, is connected to a circuit 430c, which is formed on a substrate 430a of the data driver 430, by another conductive film 450.

The data driver 430 includes the substrate 430a, a driving IC 430b, which generates an image signal to be applied to the panel 410, and the circuit 430c, which is formed on the substrate 430a. The driving IC 430b and the circuit 430c are both formed on the substrate 430a. Since the circuit 430c is connected to the driving IC 430b, the circuit 430c can transmit the image signal generated by the driving IC 430b to a flexible film 440. The circuit 430c may be connected to a circuit pattern 440b on a flexible film 440 by a conductive film 450.

A flexible film 440 includes a dielectric film 440a, which is a base film of the flexible film 440, a metal layer (not shown), which is formed on the dielectric film 440a, a circuit pattern 440b, which is formed by etching the metal layer, an IC 440c, which is connected to the circuit pattern 440b, and a protective resin 440d, which protects the IC 440c and the circuit pattern 440b.

The dielectric films 440a of the flexible films 440 may include polyimide, polyester, or a liquid crystal polymer, and may determine the physical properties of the flexible films 440 such as tensile strength, a thermal expansion coefficient and a hygroscopic property. Polyimide films may be used as the dielectric films 440a of the flexible films 440. Alternatively, liquid crystal polymer films having a high thermal expansion coefficient and an excellent hygroscopic property may be used as the dielectric films 440a of the flexible films 440. In the latter case, the flexible films 440 may be able to effectively transmit high-frequency signals because of a liquid crystal polymer having an excellent hygroscopic property.

A metal layer may be formed on a dielectric film 440b through sputtering, electroless plating or electroplating, and a circuit pattern 440b may be formed by etching the metal layer. The circuit pattern 440b is connected to an IC 440c, and is sealed by a protective resin 440d. A flexible film 440 used in a TCP may also include a device hole, which is formed in an area in which the IC 440c is disposed. On the other hand, a flexible film 440 used in a COF may not include any device hole.

Each of the flexible films 440 may also include a tin layer, which is formed on a corresponding circuit pattern 440b. More specifically, after the formation of a circuit pattern 440b by etching a metal layer, a tin layer is deposited on the circuit pattern 440b. Thereafter, the tin layer is patterned through etching. By applying heat or ultrasonic waves to the tin layer on the circuit pattern 440b, a gold-tin bond may be generated between the corresponding tin layer and a gold bump 440e, which is attached on the IC 440c.

The circuit patterns 440b of the flexible films 440 may be connected to the second electrodes 410b on the panel 410 by the conductive films 450. An image signal of the driving IC 430b of the data driver 430 is transmitted to the ICs 440c of the flexible films 440 through the circuit 430c of the data driver 430, the conductive films 450, and the circuit patterns 440b of the flexible films 440.

The ICs 440c of the flexible films 440 analyze the image signal provided by the driving IC 430b of the data driver 430 and transmit the corresponding image signal to the second electrodes 410b through the circuit patterns 440b of the flexible films 440 and the conductive films 450. Then, the second electrodes 410b receive the image signal transmitted by the ICs of the flexible films 440 and transmit the received image signal to the pixels at the intersections between the first electrodes 410a and the second electrodes 410b. If the display device 400 is driven in an active-matrix manner, the switching devices of the pixels may be driven, and thus an image may be displayed on the panel 410 according to the image signal transmitted by the second electrodes 410b.

FIG. 4C illustrates a cross-sectional view taken along line 5-5' of FIG. 4A.
Referring to FIG. 4C, the data driver 430 is connected to a flexible film 440 by a conductive film 450. The conductive film 450 may be an ACF including conductive balls 450a.

The data driver 430 includes a substrate 430a and a plurality of circuits 430c,
which are disposed on the substrate 430a. The circuits 430c transmit an image signal generated by the driving IC 430b of the data driver 430 to the flexible film 440. More specifically, the circuits 430c may be connected to circuit patterns 440b of the flexible film 440 by the conductive balls 450a, and may thus transmit the image signal generated by the driving IC 430b of the data driver 430 to the flexible film 440.

Each of the conductive balls 450a may include at least one metal layer formed of a highly-conductive metal, and may have a diameter of 5 µm or less. Referring to FIG. 4C, one or more conductive balls 450a are disposed between the circuits 430c of the data driver 430 and the circuit patterns 440b of the flexible film 440, and thus, an image signal may be transmitted from the data driver 430 to the flexible film 440 through the conductive balls 450a.

A bonding layer 440g may be formed on each of the circuit patterns 440b. The bonding layers 440g improve the bonding between the flexible film 440 and the data driver 420. The bonding layers 440g may include tin, which has a low melting point. The conductive film 450 may be disposed between the flexible film 440 and the data driver 420, and thermocompression bonding may be performed, thereby improving the efficiency of bonding the flexible film 440 and the data driver 420. The bonding layers 440g may be formed to a thickness of 50 nm to 2 µm, thereby preventing the flexible film 440 and the data driver 420 from being electrically connected.

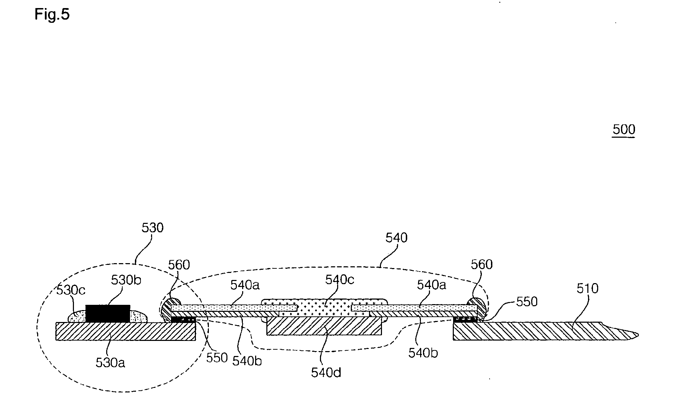

FIG. 5 is a cross-sectional view taken along line 4-4' of the display device 400 in FIG. 4A.

According to the embodiment of the present invention, the display device 500 may further comprise a resin 560 sealing up portions of the flexible film 540 contacting the conductive films 550. The resin 560 may comprise an insulating material and serve to prevent impurities that may be introduced into the portions where the flexible film 540 contacting the conductive films 550, to thus prevent damage of a signal line of the flexible film 540 connected with the panel 510 and the data driver 530, and lengthen a life span.

Although not shown, the panel 510 may comprise a plurality of scan electrodes disposed in the horizontal direction and a plurality of data electrodes disposed to cross the scan electrodes. The data electrodes disposed in the direction 4-4' are connected with the flexible film 540 via the conductive film 550 as shown in FIG. 5 in order to receive an image signal applied from the data driver 530 and thus display a corresponding image.

The data driver 530 includes a driving IC 530b formed on a substrate 530a and a protection resin 530c for protecting the driving IC 530b. The protection resin 530c may be made of a material with insulating properties and protects a circuit pattern (not shown) formed on the substrate 530a and the driving IC 530b against impurities that may be introduced from the exterior. The driving IC 530b applies an image signal to the panel 510 via the flexible film 540 according to a control signal transmitted from a controller (not shown) of the display device 500.

The flexible film 540 disposed between the panel 510 and the data driver 530 includes polyimide film 540a, metal film 540b disposed on the polyimide films 540a, an IC 540c connected with a circuit pattern printed on the metal film 540b, and a resin protection layer 540d sealing up the circuit pattern and the IC 540c.

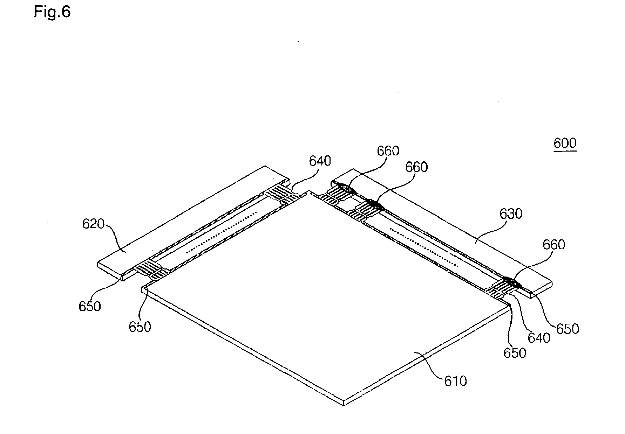

FIG. 6 illustrates diagram of a display device according to an embodiment of the present invention.

When the flexible films 640 are attached with the panel 610 and the driving units 620 and 630 through the conductive films 650, the flexible films 640 attached with the conductive films 650 can be sealed with the resin 660. With reference to FIG. 6, because the portions of the flexible films 640 attached to the conductive films 650 can be sealed with the resin 660, impurities that may be introduced from the exterior can be blocked.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A flexible film comprising:
a dielectric film; and
a metal layer disposed on the dielectric film,
wherein the metal layer comprises circuit patterns; and
a tin-based bonding layer disposed on the circuit patterns.

2. The flexible film of claim 1, wherein the dielectric film comprises at least one of polyimide, a liquid crystal polymer and polyester.

3. The flexible film of claim 1, wherein the metal layer comprises at least one of nickel, gold, chromium, and copper.

4. The flexible film of claim 1, wherein the thickness of the bonding layer is about 50 nm to 2 µm.

5. The flexible film of claim 1, wherein the bonding layer is electroless-plated on the circuit patterns.

6. A flexible film comprising:
a dielectric film;
a metal layer disposed on the dielectric film; and
an integrated circuit (IC) chip disposed on the metal layer,
wherein the metal layer comprises circuit patterns and a tin-based bonding layer formed on the circuit patterns.

7. The flexible film of claim 6, wherein the dielectric film comprises at least one of polyimide, a liquid crystal polymer and polyester.

8. The flexible film of claim 6, wherein the metal layer comprises at least one of nickel, gold, chromium, and copper.

9. The flexible film of claim 6, wherein the thickness of the bonding layer is about 50 nm to 2 µm.

10. The flexible film of claim 6, wherein the bonding layer is electroless-plated on the circuit patterns.

11. A display device comprising:
a panel;
a driving unit; and
a flexible film disposed between the panel and the driving unit,
wherein the flexible film comprises: a dielectric film; and
a metal layer disposed on the dielectric film, the metal layer comprising circuit patterns and a tin-based bonding layer formed on the circuit patterns.

12. The display device of claim 11, wherein the panel comprises:
a first electrode; and
a second electrode which intersects the first electrode,
wherein the first and second electrodes are connected to the circuit patterns.

13. The display device of claim 11, wherein the flexible film further comprises an IC chip disposed on the circuit patterns.

14. The display panel of claim 11, wherein the thickness of the bonding layer is 50 nm to 2 µm.

15. The display device of claim 11, further comprising a conductive film connecting at least one of the panel and the driving unit to the flexible film.

16. The display device of claim 15, wherein the conductive film is an anisotropic conductive film (ACF).

17. The display device of claim 11, further comprising a resin sealing up a portion of the flexible film contacting the conductive film.
